# EUROPEAN PATENT SPECIFICATION

(11) **EP 3 075 039 B1**
(45) Date of publication and mention of the grant of the patent: **01.09.2021**
(21) Application number: 14865845.3
(22) Date of filing: 26.11.2014
(51) Int. Cl.: H01S 5/06, H01S 5/026, H01S 5/34, H01S 5/024, H01S 5/028, H01S 5/042, H01S 5/12, H01S 5/22, H01S 5/227

(54) **TUNABLE SEMICONDUCTOR RADIATION SOURCE**
EINSTELLBARE HALBLEITERSTRAHLUNGSQUELLE
SOURCE DE RAYONNEMENT À SEMI-CONDUCTEUR ACCORDABLE

(30) Priority: 30.11.2013 US 201361910322 P
(43) Date of publication of application: 05.10.2016
(73) Proprietor: Thorlabs Quantum Electronics, Inc., Jessup MD 20794 (US)
(72) Inventor: CANEAU, Catherine, Genevieve, Jessup, MD 20794 (US); XIE, Feng, Jessup, MD 20794 (US); ZAH, Chung-En, Jessup, MD 20794 (US)
(74) Representative: 2s-ip Schramm Schneider Bertagnoll Patent- und Rechtsanwälte Part mbB
(86) International application number: PCT/US2014/067649
(87) International publication number: WO 2015/081220

(56) References cited:
- CN-A- 103 259 187
- JP-A- 2003 318 483
- JP-A- 2011 003 748
- US-A- 5 536 085
- US-A- 6 021 141
- US-A1- 2006 045 147
- US-A1- 2008 025 355
- US-A1- 2009 086 206
- US-A1- 2012 097 984
- GMACHL C ET AL: "Complex-coupled quantum cascade distributed-feedback laser", IEEE PHOTONICS TECHNOLOGY LETTERS, IEEE SERVICE CENTER, PISCATAWAY, NJ, US, vol. 9, no. 8, 1 August 1997 (1997-08-01), pages 1090-1092, XP011425390, ISSN: 1041-1135, DOI: 10.1109/68.605510

## Description

### BACKGROUND

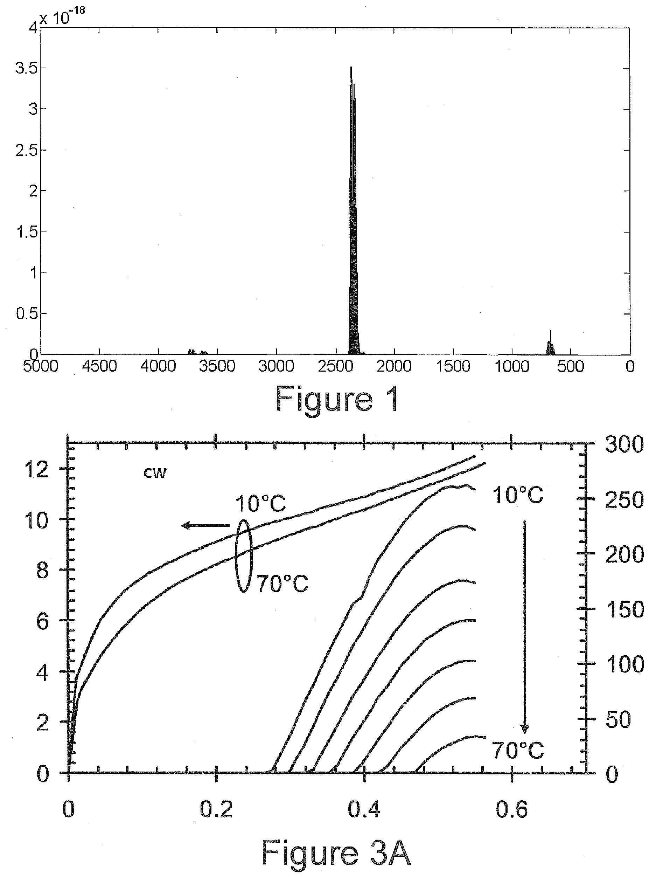

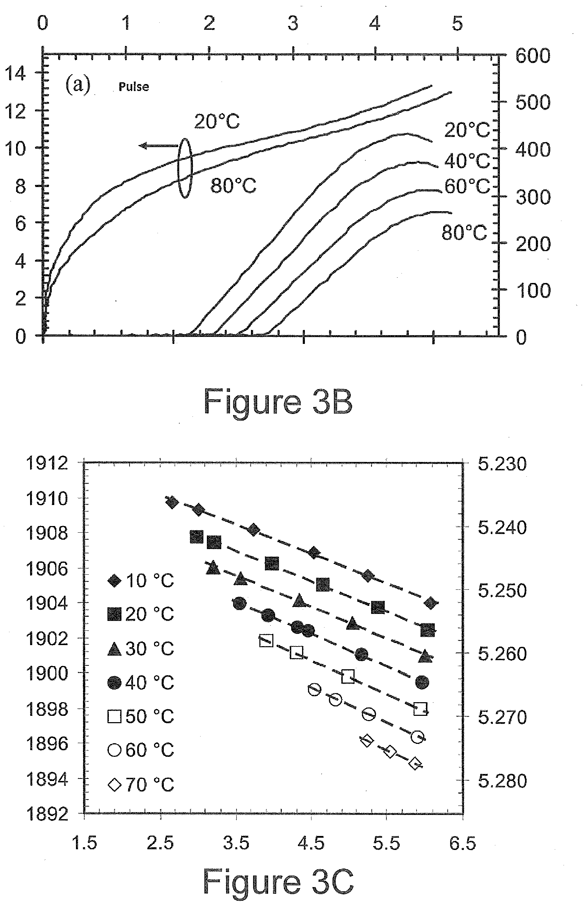

It is recognized that strong absorption lines in the mid-IR region from the vibration of chemical bonds can be used to identify molecular composition for a wide range of significant molecules, including, for example, CO₂ and explosives such as PETN, TATP, TNT, and RDX. the absorption peak of CO2 near a wavenumber of 2350 cm-1 (4.2-4.3 µm) on the horizontal axis is shown on a y-axis of line intensity (cm-1)/(molecule cm-2) in the graph of Figure 1. Using an external cavity QCL, Fuchs et al. demonstrated the capability to detect quantities of explosives like PETN, TNT, RDX, and SEMTEX with sensitivity 20 µg/cm² at distances up to 25 m. (See F. Fuchs, S. Huggera, M. Kinzera, Q. K. Yanga, W. Bronnera, R. Aidama, K. Degreifb, S. Rademacherb, F. Schnürerc, and W. Schweikertc, "Standoff detection of explosives with broad band tunable external cavity quantum cascade lasers," Proc. of SPIE vol. 8268, 82681N-1-9, 2012.) The graph of Figure 3 shows absorbance as a function of wavelength in micrometers for PETN (102), RDX (104), TATP (106), and TNT (108), together with one example of a wavelength range R of interest for used in detecting these and other substances.

In common detection methods, absorption peaks are detected as a mid-IR radiation source is tuned (or scanned) through various wavelengths suitable to characterize the target molecule(s). One way to provide such tuning is by use of an external cavity laser with a tilt-adjustable grating. While such devices can be effective as widely tunable radiation sources, one or more of the complexity, cost, reliability, and tuning speed of such sources could all potentially be improved if parts counts were reduced and particularly if mechanical moving parts were eliminated.

Accordingly, it would be desirable to provide a monolithic, wide tuning range semiconductor radiation source, particularly in the mid-IR wavelength range, since such a source enables very practical application of various beneficial detection methods.

US2009/086206 A1, JP 2003 318483 A, and US 2008/025355 A1 relate to radiation sources according to the preamble of claim 1. Providing trenches in a semiconductor radiation emitting device to control heat flow is known from CN 103 259 187A.

It is an object to provide a radiation source such that the heat from the microheater propagates principally vertically within the source.

This object is solved by the radiation sources according to the independent claims.

### BRIEF SUMMARY

The present disclosure is directed to a semiconductor radiation source comprising an active core structure comprising a semiconductor material, at least one microheater positioned above the active core structure in thermal communication with the active core structure, and at least a first electrode positioned on a side of the microheater in electrical communication with the active core structure for injecting current into the active core structure to control the current density in the active core structure. Methods of operation of the source to provide tuning of the output wavelength are also disclosed. The microheater or microheaters are used to directly control the temperature of the core structure, independent of the current density in the core structure, allowing for a wider wavelength tuning range by use of temperature and current density control in cooperation. The close proximity of the microheaters to the core structure provides fast tuning response times as short as 20 microseconds.

Further features and advantages of the present disclosure are described in or will be apparent from the further description below.

### BRIEF DESCRIPTION OF THE SEVERAL VIEWS OF THE DRAWINGS

The following detailed description of specific embodiments of the present disclosure can be best understood when read in conjunction with the following drawings, where like structure is indicated with like reference numerals and in which:
Figure 1 is a graph of an absorption spectrum of CO₂ in arbitrary units as a function of wavenumber near 2350 cm⁻¹;

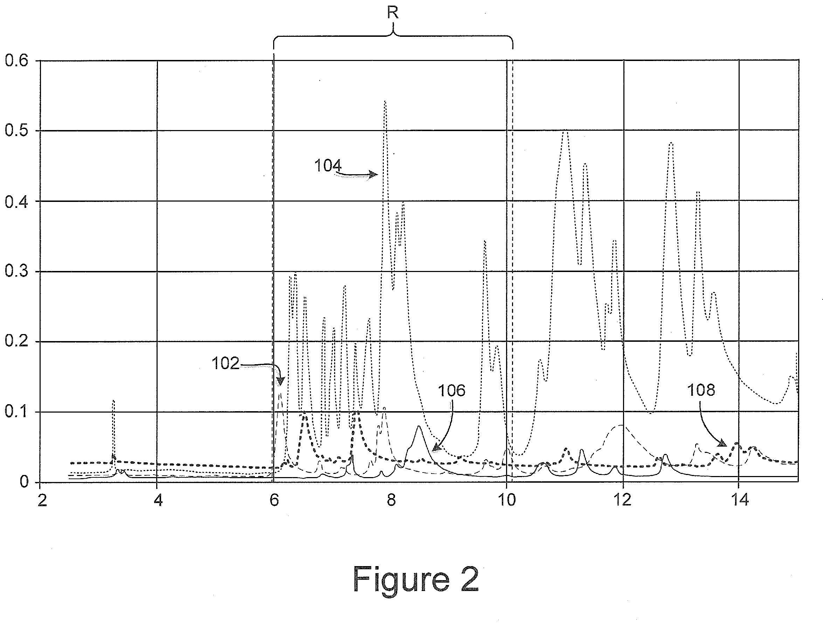

Figure 2 is a graph of absorption spectra of several common explosives in arbitrary units as a function of wavenumber;
Figure 3A is a graph showing typical performance characteristics of a distributed feedback ("DFB") quantum cascade laser ("QCL"), including voltage (in V) on the left-hand y-axis (for the top two traces) and peak power (in mW) on the right-hand y-axis, as a function of operating current (in A) on the x-axis at different submount temperatures (as labeled on the respective traces), operated in continuous ("continuous wave" or "CW") mode;
Figure 3B is a graph showing typical performance characteristics of a DFB QCL, including voltage (in V) on the left-hand y-axis (for the top two traces) and peak power (in mW) on the right-hand y-axis, as a function of operating current density on the x-axis (top of the graph) at different submount temperatures (as labeled on the respective traces), operated in pulsed mode;
Figure 3C is a graph of wavenumber (and wavelength) output of a typical DFB QCL as a function of electrical input power (in W) at different submount temperatures (labeled in the legend in the graph), operated in CW mode;
Figure 4A is a diagrammatic cross-section of one embodiment of a tunable semiconductor radiation source according to the present disclosure;
Figure 4B is a diagrammatic plan view of the embodiment according to Figure 4A or 4C, including a metallization pattern useful with the embodiment of a tunable semiconductor radiation source of figure 4A or 4C;
Figure 4C is a diagrammatic cross-section like that of Figure 4A, but with arrows showing the general paths of current flow and heat flow and showing an alternative embodiment without the grating G;
Figure 5A is a graph showing the tuning effect in wavenumber units as a function of time in microseconds using a microheater positioned generally as shown in the embodiment of Figures 4A-C, for different operating current levels (as labeled on the respective traces), beginning with turning the microheater on at time t=0;
Figure 5B is a graph showing the tuning effect in wavenumber units as a function of time in microseconds using a microheater positioned generally as shown in the embodiment of Figures 4A-C, for different operating current levels (as labeled on the respective traces), beginning with turning the microheater off at time t=0;
Figure 6A is a diagrammatic cross-section of another embodiment of a tunable semiconductor radiation source; and
Figure 6B is a diagrammatic plan view of an embodiment of a metallization pattern useful with the embodiment of a tunable semiconductor radiation source of figure 6A.

### DETAILED DESCRIPTION

Distributed feedback ("DFB") quantum cascade lasers ("QCLs") and similar devices are generally wavelength-tuned in two ways. A wavelength tuning range of are 0.3% (of center wavelength in wavenumber units) and a tuning speed (rise time) of a few microseconds may be achieved by changing the current injected into the core. A wavelength tuning range of 0.5-2% (of center wavelength in wavenumber units) and a tuning time of a few milliseconds may be achieved by changing the submount temperature.

Direct heating of the core by increased current injection quickly increases the effective refractive index (*n_{eff}*) of the waveguide, which leads to longer lasing wavelength (*λ*) by Δ*λ* = 2Δ*n_{eff}*Λ/*m* where Λ and *m* are grating period and order, respectively. However, the current injection range is limited by the rollover current of the laser, particularly under CW operation.

Figure 3A is a graph showing typical performance characteristics of a distributed feedback ("DFB") quantum cascade laser ("QCL"), including voltage (in V) on the left-hand y-axis (for the top two traces) and peak power (in mW) on the right-hand y-axis, as a function of operating current (in A) on the x-axis at different submount temperatures (as labeled on the respective traces), operated in continuous ("continuous wave" or "CW") mode. Figure 3B is a graph showing typical performance characteristics of a DFB QCL, including voltage (in V) on the left-hand y-axis (for the top two traces) and peak power (in mW) on the right-hand y-axis, as a function of operating current density on the x-axis (top of the graph) at different submount temperatures (as labeled on the respective traces), operated in pulsed mode. As seen in Figure 3A, the rollover or maximum operating current of the device, represented by rightward ends of the different traces, significantly limits the total available range of operating current. As seen in Figure 3B, where the traces are shown as a function of current density, this effect is less severe but still present in pulse mode operation.

Figure 3C is a graph of wavenumber (and wavelength) output of a typical DFB QCL as a function of electrical input power (in W) at different submount temperatures (labeled in the legend in the graph), operated in CW mode. As may be seen in Figure 3C, for CW mode operation the wavelength tuning range achieved by current injection tuning (the range achieved within each individual trace of Figure 3C) is less than that achieved by changing the submount temperature (the range achieved across all of the individual traces in Figure 3C, or between respective positions across all of the individual traces). For real time spectroscopic sensing of multiple gases, high speed tuning (faster than a millisecond) across a relatively wide wavelength range is desirable or even necessary.

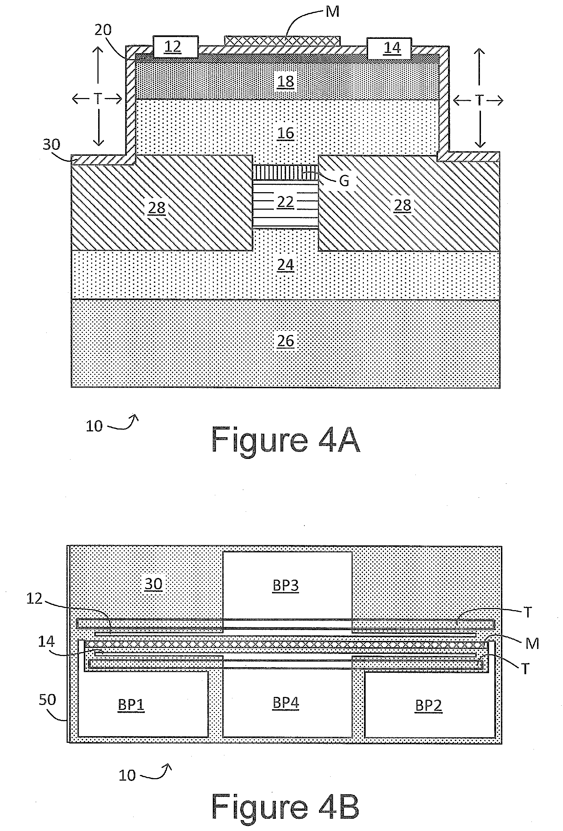

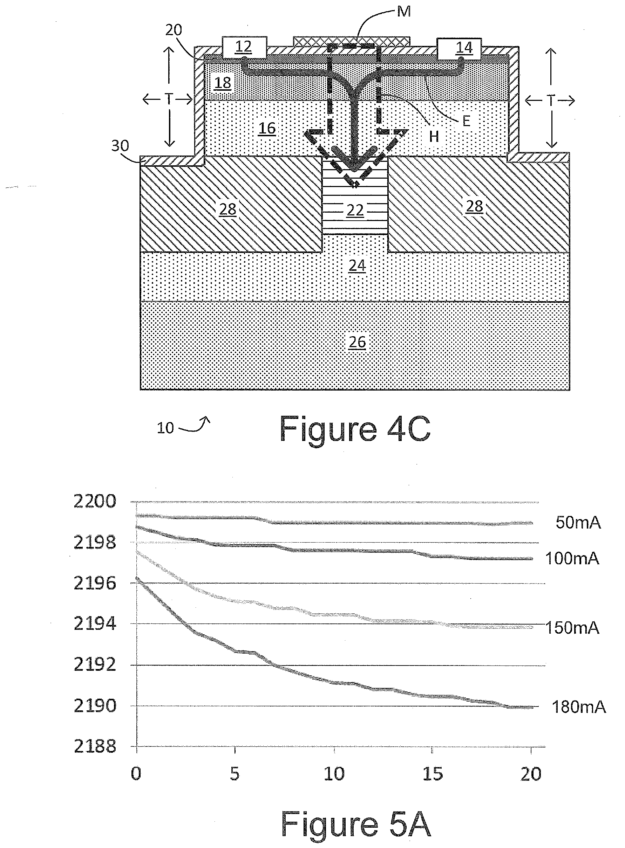

Figure 4A is a diagrammatic cross-section of one embodiment of a tunable semiconductor radiation source according to the present disclosure, and Figure 4C is a diagrammatic cross-section like that of Figure 4A, but with arrows showing the general paths of current flow and heat flow and representing an alternative embodiment without the grating G. Figure 4B is a diagrammatic plan view of the embodiment according to Figure 4A or 4C, including a metallization pattern useful with the embodiment of a tunable semiconductor radiation source of figure 4A or 4C, and an optional anti-reflection facet or coating 50.

According the embodiment and variations thereof represented in Figures 4A-C, a semiconductor radiation source 10 comprises an active core structure 22 comprising a semiconductor material and a microheater M positioned above the active core structure (desirably directly above, as shown) in thermal communication with the active core structure. The source further comprises a first electrode 12 positioned on a side of the microheater in electrical communication with the active core structure for injecting current into the active core structure to control the current density in the active core structure. Desirably, the source may also comprise a second electrode 14 positioned on a side of the microheater opposite the first electrode 12, also in electrical communication with the active core structure for injecting current into the active core structure to control the current density in the active core structure. The source further comprises a top cladding layer 16 above the active core structure 20 and below the microheater M, the top cladding layer 16 being an n-doped layer. The source further comprises additional top cladding layers 18, 20, also n-doped, with successively higher doping in the respective order: layer 16, layer 18, layer 20, desirably N⁻ InP, n⁺ InP, and n⁺⁺InP and/or n⁺⁺ InGaAs, respectively. The source 10 may also desirably include an insulating or passivating layer 30, desirably comprised of Si₃N₄ or SiO₂, which surrounds the electrode 12 and, if present, the electrode 14, and on which the microheater M rests.

The active core structure 22 of the source 10 desirably comprises a) quantum cascade stages, b) interband cascade stages, c) single or multiple quantum wells, or any combination of these. The active core structure are desirably positioned on lower cladding layers 24, 26 of N-type, preferably with successively higher doping in the respective order: 24, 26, desirably N⁻ InP and n⁺InP, respectively. The core structure may be bounded (in the sideways direction of the Figures 4A and 4C) by a semi-insulating layer 28, desirably semi-insulating InP.

Trenches T are provided along both sides of the microheater, in this case positioned along the outer edges of the electrodes 12, 14. The trenches T help ensure that heat from the microheater M propagates principally vertically within the source 10 (that is, in the vertical direction of the figures, downward toward the core structure 22), rather than both vertically and horizontally.

The source 10 may further comprise a distributed feedback grating G on and/or in the active core structure 22. Alternatively, the source 10 may have no distributed feedback grating on and/or in the active core structure 22, (that is, grating G shown in Figure 4A is optional, and may be omitted as shown in the alternative embodiment of Figure 4C) and further including, in the case of no grating G, a low reflective facet or anti-reflective coating 50 (Figure 4B) optically coupled to the active core structure 22 to allow for operation of the source 10 as low coherency amplified spontaneous emission source. In either embodiment, the wavelength range of the source 10 is desirably in the visible or near infrared. In particular, the wavelength range of the source 10 is desirably within the range of from 0.4 to 20 µm.

The view of Figure 4C includes arrows E and H showing the general path of current (E) and heat (H) flow in the embodiments of Figures 4A and 4C. The plan view of Figure 4B shows an embodiment of a metallization or bonding pad arrangement, with two bonding pads BP1, BP2 electrically connected to the microheater M, and a bonding pad BP3 electrically connected to electrode 12 for supplying injection current to the core structure 22, and another (optional) bonding pad BP4 electrically connected to electrode 14 also for supplying injection current to the core structure 20.

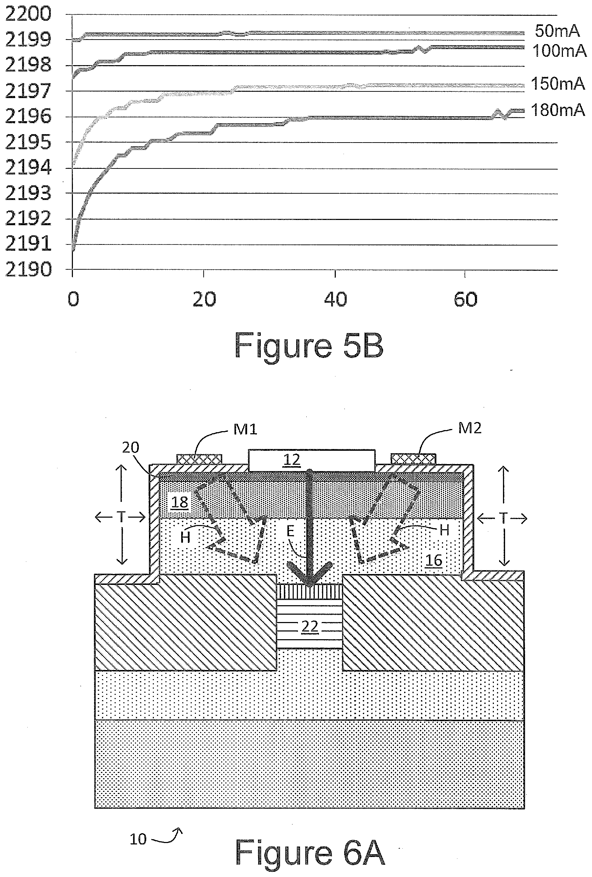

With the top-side centered heater (microheater M) according to the embodiments of Figures 4A-C, the temperature of the core structure 22 can be changed very quickly. Figure 5A is a graph showing the tuning effect in wavenumber units as a function of time in microseconds using a microheater positioned generally as shown in the embodiment of Figures 4A-C, for different operating current levels (as labeled on the respective traces), beginning with turning the microheater on at time t=0, and Figure 5B is a graph showing the tuning effect in wavenumber units as a function of time in microseconds using a microheater positioned generally as shown in the embodiment of Figures 4A-C, for different operating current levels (as labeled on the respective traces), beginning with turning the microheater off at time t=0. The core temperature rise time due to a change in current through the top heater is about 20 microseconds as shown in Fig. 5A. This is achieved in part because the heater is centered directly above the core and the heater is located very close to the core (within ∼5 µm in the vertical direction of Figures 4A and 4C). Temperature fall time is a little slower, but still very quick at about 40 microseconds as shown in Figure 5B. The lasing or ASE emission is separately controlled by current injection into the core structure 22 from the side electrodes 12, 14. This allows the source to be operated in either pulse or continuous mode, with wide and fast tenability in either mode.

As mentioned above, Figures 3A and 3B show the light-current-voltage characteristics of a typical DFB QCL as a function of submount temperature under CW operation (Figure 3A) and pulsed operation (Figure 3B), and Figure 3C shows CW lasing wavenumber (wavelength) as a function of input electrical power (laser operating current x voltage) of a typical DFB QCL at different submount temperatures. As may be seen from Figure 3C, the lower the submount temperature, the larger is the fast wavelength tuning range by current injection alone (5.6 cm⁻¹ or 0.3% of center wavelength at 10 °C). A still wider, but slow tuning range of 9.2 cm⁻¹ (0.5% of center wavelength) can be achieved by changing the submount temperature from 10 to 70°C alone. An even wider tuning range of 14.8 cm⁻¹ (0.8% of center wavelength) can be achieved by combining the current and submount temperature tuning from 10 to 70°C. In the present disclosure, the top heater microheater M) is used to change the core temperature instead of changing the submount temperature (which is generally kept constant through a thermal electrical cooler, or optionally by heat sink or other atmospheric coupled cooling) to widen the fast wavelength tuning range of the sources of the present disclosure. Moreover, the core temperature (absent separate heating) is lower under pulsed operation than under CW operation for a given submount temperature, such that the blue side of the wavelength tuning range is extended under pulsed operation, relative to that shown in Figure 3C. This additional wavelength range can be estimated by extrapolating the top trace out to zero electrical power in Figure 3C. In other words, we can further increase the wavelength tuning range by operating the source in pulsed mode, while increasing the tuning speed by the wavelength using a microheater on the top of the core. Wavelength chirping due to injection-current-induced heating within the pulse duration may be minimized by the use of pulses with short duration such as 50 ns or less.

For embodiments where the source of the present disclosure includes a DFB grating and is operated in lasing mode, significantly wider wavelength tuning range than a traditional DFB laser module (having with one electrode for current injection). Tuning may also be achieved in continuous fashion without spectral mode hop, which is difficult to achieve usin a typical distributed Bragg reflector (DBR) laser and EC-QCL modules. Faster tuning and smaller size and more robust configuration (or package) than a typical EC-QCL module may also be achieved. The above attributes should allow production of a compact wavelength tunable module for real time spectroscopic sensing of multiple gases with high yield and low cost.

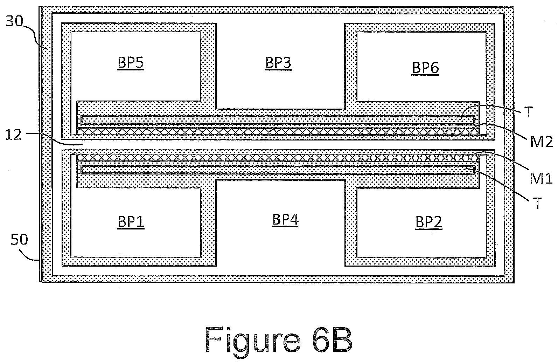

Figure 6A is a diagrammatic cross-section of another embodiment of a tunable semiconductor radiation source, and Figure 6B is a diagrammatic plan view including a metallization pattern useful with the embodiment of a tunable semiconductor radiation source of figure 6A. In the embodiment of Figures 6A-B, a semiconductor radiation source 10 comprises an active core structure 22 comprising a semiconductor material, an electrode 12 positioned above the active core structure 22 in electrical communication with the active core structure 22 for injecting current into the active core structure to control the current density in the active core structure 22, and two microheaters M1, M2 positioned to the sides of the electrode 12 in thermal communication with the active core structure 22. As in the embodiment of Figures 4A-C, the source 10 further comprises a top cladding layer 16 above the active core structure and below the microheaters M1, M2, the top cladding layer 16 being an n-doped layer. The active core structure 22 desirably comprises quantum cascade stages, interband cascade stages, or single or multiple quantum wells or combinations of these.

The source 10 of Figures 6A-B further comprises trenches T along a single side of each of the two microheaters M1, M2 opposite from the electrode 12.

The source 10 of Figures 6A-B may further comprise a distributed feedback grating G positioned in and/or on the active core structure, or, alternatively, the source 10 may have no distributed feedback grating G and may further comprise a low reflective facet or low reflectivity coating 50 optically coupled to the active core structure to allow for operation of the source as low coherency amplified spontaneous emission source. The source 10 desirably operates in the wavelength range of the visible or near infrared, more desirably in the wavelength range of from 0.4 to 20µm. As seen in Figure 6B, two bonding pads BP1 And BP2 may be provided in electrical connection with the first microheater M1, and an additional two bonding pads BP5 And BP6 may be provided in electrical connection with the second microheater M2. One or two additional bonding pads BP3, BP4 may provide electrical connection to the electrode 12. One advantage of the embodiment of Figures 6A-B seen in Figure 6B is that electrical leads do not cross the trenches T.

The embodiment of source 10 of Figures 6A-B is not most preferred for tuning speed, however, relative to the embodiment of Figures 4A-C, because of the relatively longer path H travelled by heat from the microheaters M1, M2. Nonetheless, the tuning range is relatively wide and accordingly the embodiment of Figures 6A-B may be beneficial where medium-speed, wide-range tuning is desired.

The present disclosure also encompasses methods of providing radiation from a semiconductor radiation source, comprising tuning the output wavelength(s) of a radiation source 10 according to the present disclosure by passing current through the microheater M or microheaters M1, M2 of the source to heat the active core structure 22 of the source 10.

In one alternative, the method may further comprise operating the source 10 under continuous wave (CW) operation, and, in addition to tuning the output wavelength(s) of the source 10 by passing current through the microheater M or microheaters M1. M2, varying the current injected into the active core structure 22 by the electrode 12 or electrodes 12, 14 to further tune the output wavelength(s). In a second alternative, the method may further comprise operating the source under pulse operation, desirably under short pulse operation (equal to or less than about 50ns to minimize (thermally-induced) wavelength chirping.

## Claims

1. A semiconductor radiation source (10) comprising:
an active core structure (22) comprising a semiconductor material,
a microheater (M) positioned above the active core structure in thermal communication with the active core structure,
a top cladding layer (16) above the active core structure, and below the microheater,
a first electrode (12) positioned on a side of the microheater (M) in electrical communication with the active core structure for injecting current into the active core structure (22) to control the current density in the active core structure;
**characterized in that**
the source further comprises
additional top cladding layers (18, 20) positioned between the active core and the microheater (M), and
the top cladding layer and the additional top cladding layers comprising trenches (T) along both sides of the microheater (M), such that heat from the microheater propagates principally vertically within the source toward the core structure; and
the top cladding layer and the additional top cladding layers (16, 18, 20) are n-doped, with the layers having successively higher doping in the ascending order towards the microheater (M).

2. The source of claim 1 comprising a second electrode (14) positioned on a side of the microheater opposite the first electrode (12) for injecting current into the active core structure to control the current density in the active core structure.

3. The source according to any of claims 1-2 wherein the active core structure comprises quantum cascade stages.

4. The source according to any of claims 1-3 wherein the active core structure comprises interband cascade stages

5. The source according to any of claims 1-4 wherein the active core structure comprises single or multiple quantum wells.

6. The source according to any of claims 1-5 further comprising a distributed feedback grating on and/or in the active core structure.

7. The source according to any of claims 1-5 not comprising a distributed feed-back grating on and/or in the active core structure and further including a low reflective facet optically coupled to the active core structure configured for operation of the source as low coherency amplified spontaneous emission source.

8. The source according to any of claims 1-7 wherein the wavelength range of the source is in the visible or near infrared.

9. The source according to any of claims 1-7 wherein the wavelength range of the source is within the range of from 0.4 to 20 µm.

10. A semiconductor radiation source comprising:
an active core structure (22) comprising a semiconductor material,
an electrode (12) positioned above the active core structure in electrical communication with the active core structure for injecting current into the active core structure to control the current density in the active core structure,
two microheaters (M1, M2) positioned to the sides of the electrode in thermal communication with the active core structure,
a top cladding layer (16) above the active core structure, and below the microheaters (M1, M2);
**characterized in that**
the source further comprises
additional top cladding layers (18, 20) positioned between the active core and the microheaters (M1, M2), and
the top cladding layer and the additional top cladding layers comprising trenches (T) along a single side of each of the two microheaters, such that heat from the microheaters propagates principally vertically within the source toward the core structure; and
the top cladding layer and the additional top cladding layers (16, 18, 20) are n-doped with the layers having successively higher doping in the ascending order towards the microheaters (M1, M2).

11. The source according to claim 10 wherein the active core structure comprises quantum cascade stages.

12. The source according to any of claims 10-11 wherein the active core structure comprises interband cascade stages.

## Patentansprüche

1. Halbleiterstrahlungsquelle (10), die Folgendes umfasst:
eine aktive Kernstruktur (22), die ein Halbleitermaterial umfasst,
einen Mikroheizer (M), der über der aktiven Kernstruktur in thermischer Kommunikation mit der aktiven Kernstruktur angeordnet ist,
eine obere Mantelschicht (16) über der aktiven Kernstruktur und unter dem Mikroheizer,
eine erste Elektrode (12), die auf einer Seite des Mikroheizers (M) in elektrischer Verbindung mit der aktiven Kernstruktur zum Injizieren von Strom in die aktive Kernstruktur (22) angeordnet ist, um die Stromdichte in der aktiven Kernstruktur zu steuern;
**dadurch gekennzeichnet, dass**
die Quelle ferner zusätzliche obere Mantelschichten (18, 20) umfasst, die zwischen dem aktiven Kern und dem Mikroheizer (M) angeordnet sind, und
die obere Mantelschicht und die zusätzlichen oberen Mantelschichten Trenches (T) entlang beider Seiten des Mikroheizers (M) derart umfassen, dass sich Wärme von dem Mikroheizer hauptsächlich vertikal innerhalb der Quelle zu der Kernstruktur hin ausbreitet; und
die obere Mantelschicht und die zusätzlichen oberen Mantelschichten (16, 18, 20) n-dotiert sind, wobei die Schichten eine sukzessiv höhere Dotierung in der aufsteigenden Reihenfolge zu dem Mikroheizer (M) hin aufweisen.

2. Quelle nach Anspruch 1, die eine zweite Elektrode (14) umfasst, die auf einer Seite des Mikroheizers gegenüber der ersten Elektrode (12) zum Injizieren von Strom in die aktive Kernstruktur angeordnet ist, um die Stromdichte in der aktiven Kernstruktur zu steuern.

3. Quelle nach einem der Ansprüche 1-2, wobei die aktive Kernstruktur Quantenkaskadenstufen umfasst.

4. Quelle nach einem der Ansprüche 1-3, wobei die aktive Kernstruktur Interbandkaskadenstufen umfasst.

5. Quelle nach einem der Ansprüche 1-4, wobei die aktive Kernstruktur einzelne oder mehrere Quantentöpfe umfasst.

6. Quelle nach einem der Ansprüche 1-5, die ferner ein verteiltes Rückkopplungsgitter auf und/oder in der aktiven Kernstruktur umfasst.

7. Quelle nach einem der Ansprüche 1-5, die kein verteiltes Rückkopplungsgitter auf und/oder in der aktiven Kernstruktur umfasst und ferner eine wenig reflektierende Facette beinhaltet, die mit der aktiven Kernstruktur optisch gekoppelt ist, die für einen Betrieb der Quelle als eine Quelle von verstärkter spontaner Emission mit niedriger Kohärenz konfiguriert ist.

8. Quelle nach einem der Ansprüche 1-7, wobei der Wellenlängenbereich der Quelle sich in dem sichtbaren oder Nah-Infrarot-Bereich befindet.

9. Quelle nach einem der Ansprüche 1-7, wobei der Wellenlängenbereich der Quelle sich innerhalb des Bereichs von 0,4 bis 20 µm befindet.

10. Halbleiterstrahlungsquelle, die Folgendes umfasst:
eine aktive Kernstruktur (22), die ein Halbleitermaterial umfasst,
eine Elektrode (12), die über der aktiven Kernstruktur in elektrischer Kommunikation mit der aktiven Kernstruktur zum Injizieren von Strom in die aktive Kernstruktur angeordnet ist, um die Stromdichte in der aktiven Kernstruktur zu steuern,
zwei Mikroheizer (M1, M2), die an den Seiten der Elektrode in thermischer Verbindung mit der aktiven Kernstruktur angeordnet sind,
eine obere Mantelschicht (16) über der aktiven Kernstruktur und unter den Mikroheizern (M1, M2);
**dadurch gekennzeichnet, dass**
die Quelle ferner zusätzliche obere Mantelschichten (18, 20) umfasst, die zwischen dem aktiven Kern und den Mikroheizern (M1, M2) angeordnet sind, und
die obere Mantelschicht und die zusätzlichen oberen Mantelschichten Trenches (T) entlang einer einzelnen Seite jedes der zwei Mikroheizer derart umfassen, dass sich Wärme von dem Mikroheizer hauptsächlich vertikal innerhalb der Quelle zu der Kernstruktur hin ausbreitet; und
die obere Mantelschicht und die zusätzlichen oberen Mantelschichten (16, 18, 20) n-dotiert sind, wobei die Schichten die sukzessiv höhere Dotierung in der aufsteigenden Reihenfolge zu den Mikroheizern (M1, M2) hin aufweisen.

11. Quelle nach Anspruch 10, wobei die aktive Kernstruktur Quantenkaskadenstufen umfasst.

12. Quelle nach einem der Ansprüche 10-11, wobei die aktive Kernstruktur Interbandkaskadenstufen umfasst.

## Revendications

1. Source de rayonnement à semi-conducteur (10) comprenant :
une structure de cœur actif (22) comprenant un matériau semi-conducteur,
un micro-réchauffeur (M) positionné au-dessus de la structure de cœur actif en communication thermique avec la structure de cœur actif,
une couche de revêtement supérieur (16) au-dessus de la structure de cœur actif, et en dessous du micro-réchauffeur,
une première électrode (12) positionnée sur un côté du micro-réchauffeur (M) en communication électrique avec la structure de cœur actif pour injecter du courant dans la structure de cœur actif (22) afin de commander la densité de courant dans la structure de cœur actif ;
**caractérisé en ce que**
la source comprend en outre
des couches de revêtement supérieur supplémentaires (18, 20) positionnées entre le cœur actif et le micro-réchauffeur (M), et
la couche de revêtement supérieur et les couches de revêtement supérieur supplémentaires comprenant des tranchées (T) le long des deux côtés du micro-réchauffeur (M), de telle sorte que la chaleur du micro-réchauffeur se propage principalement verticalement à l'intérieur de la source vers la structure de cœur ; et
la couche de revêtement supérieur et les couches de revêtement supérieur supplémentaires (16, 18, 20) sont dopées n, les couches ayant successivement
un dopage plus élevé dans l'ordre croissant vers le micro-réchauffeur (M).

2. Source selon la revendication 1, comprenant une seconde électrode (14) positionnée sur un côté du micro-réchauffeur opposé à la première électrode (12) pour injecter du courant dans la structure de cœur actif afin de réguler la densité de courant dans la structure de cœur actif.

3. Source selon l'une quelconque des revendications 1 à 2, la structure de cœur actif comprenant des étages en cascade quantique.

4. Source selon l'une quelconque des revendications 1 à 3, la structure de cœur actif comprenant des étages en cascade interbande

5. Source selon l'une quelconque des revendications 1 à 4, la structure de cœur actif comprenant un ou plusieurs puits quantiques.

6. Source selon l'une quelconque des revendications 1 à 5 comprenant en outre un réseau de rétroaction distribué sur et/ou dans la structure de cœur actif.

7. Source selon l'une quelconque des revendications 1 à 5 ne comprenant pas un réseau de rétroaction distribué sur et/ou dans la structure de cœur actif et comportant en outre une facette à faible réflexion couplée optiquement à la structure de cœur actif configurée pour la mise en fonctionnement de la source en tant que source d'émission spontanée amplifiée à faible cohérence.

8. Source selon l'une quelconque des revendications 1 à 7, la plage de longueurs d'onde de la source étant dans le visible ou le proche infrarouge.

9. Source selon l'une quelconque des revendications 1 à 7 la plage de longueurs d'onde de la source se situant à l'intérieur de la plage de 0,4 à 20 µm.

10. Source de rayonnement à semi-conducteur comprenant :
une structure de cœur actif (22) comprenant un matériau semi-conducteur,
une électrode (12) positionnée au-dessus de la structure de cœur actif en communication électrique avec la structure de cœur actif pour injecter du courant dans la structure de cœur actif afin de commander la densité de courant dans la structure de cœur actif,
deux micro-réchauffeurs (M1, M2) positionnés sur les côtés de l'électrode en communication thermique avec la structure de cœur actif,
une couche de revêtement supérieur (16) au-dessus de la structure de cœur actif, et en dessous des micro-réchauffeurs (M1, M2) ;
**caractérisé en ce que**
la source comprend en outre
des couches de revêtement supérieur supplémentaires (18, 20) positionnées entre le cœur actif et les micro-réchauffeurs (M1, M2), et
la couche de revêtement supérieur et les couches de revêtement supérieur supplémentaires comprenant des tranchées (T) le long d'un seul côté de chacun des deux micro-réchauffeurs, de telle sorte que
la chaleur des micro-réchauffeurs se propage principalement verticalement à l'intérieur de la source vers la structure centrale ; et
la couche de revêtement supérieur et les couches de revêtement supérieur supplémentaires (16, 18, 20) sont dopées n, les couches ayant successivement
un dopage supérieur dans l'ordre croissant vers les micro-réchauffeurs (M1, M2).

11. Source selon la revendication 10 la structure de cœur actif comprenant des étages en cascade quantique.

12. Source selon l'une quelconque des revendications 10 à 11 la structure de cœur actif comprenant des étages en cascade interbande.
